**Europäisches Patentamt**

**European Patent Office**

**Office européen des brevets**

(19)

(11) **EP 1 219 939 A2**

(12) **EUROPEAN PATENT APPLICATION**

(43) Date of publication:
**03.07.2002 Bulletin 2002/27**

(51) Int Cl.7: **G01J 9/02**

(21) Application number: **01130887.1**

(22) Date of filing: **27.12.2001**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **25.12.2000 JP 2000391817**

(71) Applicant: **Nippon Sheet Glass Co., Ltd.**
**Osaka-shi, Osaka 541-8559 (JP)**

(72) Inventors:
- **Kittaka, Shigeo, Nippon Sheet Glass Co.Ltd.**
  **Osaka-shi, Osaka (JP)**
- **Koyama, Tadashi, Nippon Sheet Glass Co.Ltd.**
  **Osaka-shi, Osaka (JP)**
- **Sasaki, Yasuji, Nippon Sheet Glass Co.Ltd.**
  **Osaka-shi, Osaka (JP)**

(74) Representative: **HOFFMANN - EITLE**
**Patent- und Rechtsanwälte**
**Arabellastrasse 4**
**81925 München (DE)**

(54) **Wavelength monitoring apparatus**

(57)     A wavelength monitoring apparatus according to the present invention constituted by: an optical device made of a periodic multilayer structure; a beam source optically connected to at least one end surface of the multilayer structure, the one end surface being not parallel to layer surfaces of the mutilayer structure; and a beam detecting means provided for detecting beam made to exit from at least one surface of the multilayer structure at a specific angle with respect to a specific wavelength, the one surface being parallel to the layer surfaces of the mutilayer structure.

FIG.6

EP 1 219 939 A2

**Description**

BACKGROUND OF THE INVENTION

The present invention relates to a wavelength monitoring apparatus used in an optical communication system, an optical measuring system, or the like.

In recent years, increase in capacity of an optical fiber communication network has been strongly demanded because of the rapid advance of popularization of Internet. Development of wavelength division multiplexing (WDM) communication as means for increasing the capacity has been advanced rapidly. An optical function device such as an optical demultiplexer, a filter or an isolator good in wavelength selectivity is necessary for such WDM communication because beam components with slightly different wavelengths are used for transferring different kinds of information individually. It is a matter of course that the aforementioned function device is strongly demanded in mass-production efficiency, reduction in size, integration in density, stability, and so on.

In wavelength division multiplexing optical communication, a beam source for emitting beam with a plurality of wavelengths is re quired because optical signals with a plurality of wavelengths multiplexed artificially are used. In the initial stage of wavelength division multiplexing communication, a large interval was provided between wavelengths such as 1.3 μm and 1.55 μm. With the increase in communication capacity in the recent years, however, in the vicinity of 1.55 μm, wavelength multiplexing in a frequency interval of 100 GHz (wavelength interval of about 0.8 nm), and further, wavelength multiplexing in a frequency interval of 50 GHz (wavelength interval of about 0.4 nm) have been required, and practical use of such wavelength multiplexing has been already advanced. Hence, as the wavelength interval is reduced in the aforementioned manner, wavelength stability of a semiconductor laser used as a beam source becomes important.

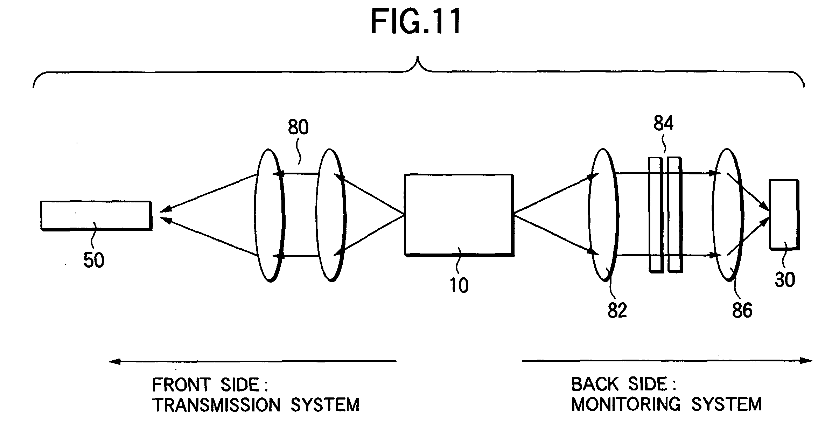

Because the oscillation wavelength of the semiconductor laser is remarkably affected by temperature, a wavelength monitoring mechanism is generally provided. A monitoring output signal of the wavelength monitoring mechanism is fed back to a temperature controller so that the oscillation wavelength is controlled to be kept constant. Fig. 11 shows an example of a wavelength monitoring optical system using an etalon (Fabry-Perot optical resonator) (for example, see IEEE Photonic Technology Letters, Vol.11, No.11, p.1431, 1999). The left side of a semiconductor laser (LD) 10 located in the center is a so-called front side which shows an optical system for transmitting an optical signal. An optical signal made to exit from a front end surface of the LD 10 is coupled to an optical fiber 50 by use of a lens system 80 so as to be transmitted. The right side of the LD 10 is a so-called back side which shows an optical system for monitoring the oscillation wavelength of the LD. Beam emitted from a rear end surface of the LD 10 is used for monitoring the wavelength. The beam emitted from the LD 10 is collimated as parallel beams by a collimator lens 82, so that the parallel beams enter the etalon 84. The beams transmitted through the etalon 84 are condensed into a photo detector 30 by a condenser lens 86. The resonator length of the etalon 84 is adjusted so accurately as to correspond to the wavelength to be monitored. When the wavelength fluctuates, the quantity of transmitted beam fluctuates. Hence, the change of the quantity of transmitted beam is detected as the fluctuation of the output of the photo detector 30. An output signal of the photo detector 30 is fed back to a temperature controller (not shown) of the LD 10 to thereby make it possible to suppress the fluctuation of the oscillation wavelength of the LD 10. Instead of the etalon, an optical device having a spectroscopic function or a filter function may be used for detecting the wavelength fluctuation. Examples of the optical device are an optical filter, an optical fiber-Bragg diffraction grating, etc.

As described above by way of example, the background-art wavelength monitoring apparatus is constituted by an optical system for collimating beam emitted from the LD and making the collimated beam incident on a photo detector through an optical device. In such an optical system, optical parts such as a lens, and so on, are required for bringing effective optical coupling. Moreover, accurate adjustment is required. Hence, it is difficult to reduce the size of the apparatus as a whole. Moreover, the number of parts increases. Hence, there is a problem that it is difficult to retain stability against the fluctuation of temperature and the change of environment such as a shock.

SUMMARY OF THE INVENTION

To solve the aforementioned problem, an object of the present invention is to provide a wavelength monitoring apparatus which is small-sized and which can be used without adjustment.

The wavelength monitoring apparatus according to the present invention is constituted by an optical device made of a periodic mutilayer structure; a beam source optically connected to at least one end surface of the multilayer structure, the one end surface being not parallel to layer surfaces of the mutilayer structure; and a beam detecting means provided for detecting beam made to exit from at least one surface of the multilayer structure at a specific angle with respect to a specific wavelength, the one surface being parallel to the layer surfaces of the mutilayer structure.

As an embodiment of the optical device made of a periodic multilayer structure, the optical device is made of a multilayer film formed on a substrate transparent to the wavelength used. A semiconductor can be used as the beam source. A photo detector can be used as the beam detecting means.

In this case, it is preferable that the semiconductor laser and the photo detector are integrated on a substrate on which the multilayer film is formed. On this occasion, beam emitted from the semiconductor laser can be coupled to a beam incidence end surface of the multilayer film by level differences provided on the substrate on which the multilayer film is formed. In addition, the photo detector can be provided on a surface opposite to the surface of the substrate on which the multilayer film is formed.

In the wavelength monitoring apparatus according to the present invention, the fluctuation of the wavelength is detected as a change of the exit angle by the operation of the periodic multilayer structure which functions as one-dimensional photonic crystal. Because the change of the exit angle on the basis of the fluctuation of the wavelength is very large, for example, compared with that in a background-art diffraction grating or the like, the size of the apparatus can be reduced as a whole. In addition, because such a periodic multilayer structure is generally formed on a substrate, the periodic multilayer structure is suitable for integration of the beam source and the beam detecting means on one and the same substrate. Hence, optical parts such a lens, and so on, are not required, so that a wavelength monitoring apparatus small in size and excellent in stability can be provided.

The present disclosure relates to the subject matter contained in Japanese patent application No. 2000-391817 (filed on December 25, 2000), which is expressly incorporated herein by reference in its entirety.

BRIEF DESCRIPTION OF THE DRAWINGS

Fig. 1 is a typical view showing an effect of a periodic multilayer structure which is the base of the present invention.

Fig. 2 is a view showing the basic configuration of the periodic multilayer structure.

Fig. 3 is a view showing a refractive angle of beam incident onto a homogeneous thin film layer.

Fig. 4 is a view showing an example of photonic band graphs in the periodic multilayer structure.

Fig. 5 is a view showing the relation between guided beam and refracted beam in a third band of the periodic multilayer structure.

Fig. 6 is a view showing an embodiment of a wavelength monitoring apparatus according to the present invention.

Fig. 7 is a view showing a mode in use of the wavelength monitoring apparatus according to the present invention.

Fig. 8 is a view showing another mode in use of the wavelength monitoring apparatus according to the present invention.

Fig . 9 is a view showing a further mode in use of the wavelength monitoring apparatus according to the present invention.

Fig. 10 is a view showing a still further mode in use of the wavelength monitoring apparatus according to the present invention.

Fig. 11 is a view showing the configuration of a background-art apparatus for monitoring the wavelength of a semiconductor laser.

DESCRIPTION OF THE PREFERRED EMBODIMENT

A mode for carrying out the present invention will be described below specifically.

Among optical function devices, an optical device, in which a multilayer film formed from thin films each having a thickness equal to or smaller than the wavelength of beam and laminated on a substrate such as a quartz substrate or a glass substrate is used as an anti-reflection film, a polarization separating filter, a wavelength selective filter, or the like, has been already put into practical use and has been used widely.

In most cases, use of such an optical multilayer film is generally conceived upon the assumption of beam rays which pass through the uppermost layer surface to the lowermost layer surface of the multilayer film provided on a surface of the substrate. There is none but the following example as an example in which an end surface of the multilayer film, that is, a surface where the periodic structure is exposed, is used as a beam incidence surface or as a beam exit surface.

Theoretical analysis in a direction of beam rays incident on a section of an inclined multilayer film has been described (Applied Physics B, Vol.39, p.231, 1986). The fact that the same polarization separating effect as that of a birefringent material is obtained by use of properties (so-called structural birefringence) of the multilayer film the refractive index of which varies in accordance with TE and TH polarized beam has been disclosed to attempt separation of polarized beam due to structural birefringence (Optics Letters Vol.15, No.9, p.516, 1990). Therehasbeenfurtherareportthattheperiodicmultilayer film is regarded as one-dimensional photonic crystal for obtaining very large dispersion (superprism effect) because the first band is shaped linearly in a neighbor of the band gap ("International Workshop on Photonic and Electromagnetic Crystal Structures" Technical Digest, F1-3).

The inventors of this application suggested by fruits of those basic studies have devised an optical device as follows.

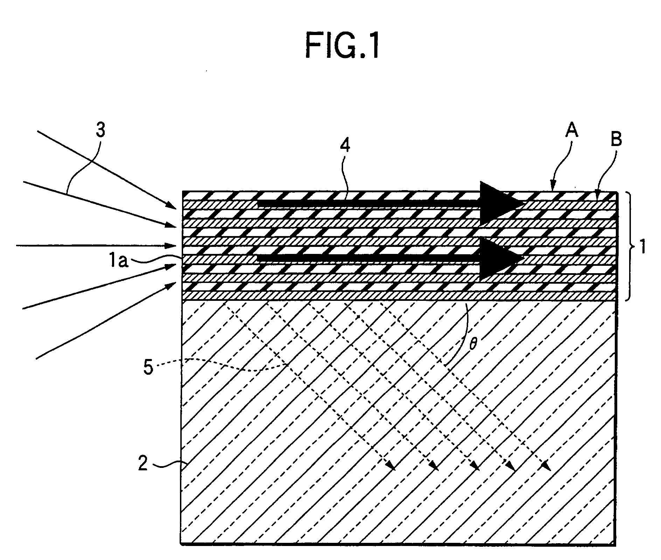

Fig. 1 is a sectional view typically showing an optical device according to an embodiment of the present invention. A multilayer film 1 having periods is formed on a surface of a parallel and planar transparent substrate 2. For example, the multilayer film is provided as a structure in which materials A (refractive index: $n_A$) each having a thickness $t_A$ and materials B (refractive index: $n_B$) each having a thickness $t_B$ are laminated alternately with $\underline{a} = (t_A + t_B)$ as a period.

According to the inventors' experiment, when laser beam (incident beam) 3 with a wavelength $\lambda$ is made incident on an end surface 1a of the multilayer film 1 after the end surface 1a is polished, a large part of beam serves as guided beam 4 in the inside of the multilayer film 1. A part of beam, however, serves as beam 5 leaked to the substrate 2 side. The direction (angle $\theta$) of the leaked beam 5 is approximately constant with respect to the wavelength $\lambda$, so that the leaked beam 5 forms luminous flux with very good directivity. Moreover, because the value of $\theta$ varies largely in accordance with the value of $\lambda$, the multilayer film 1 can detect the change of the wavelength of the incident beam 3 as a change of the angle $\theta$ with high sensitivity.

The principle of the aforementioned phenomenon will be described in brief.

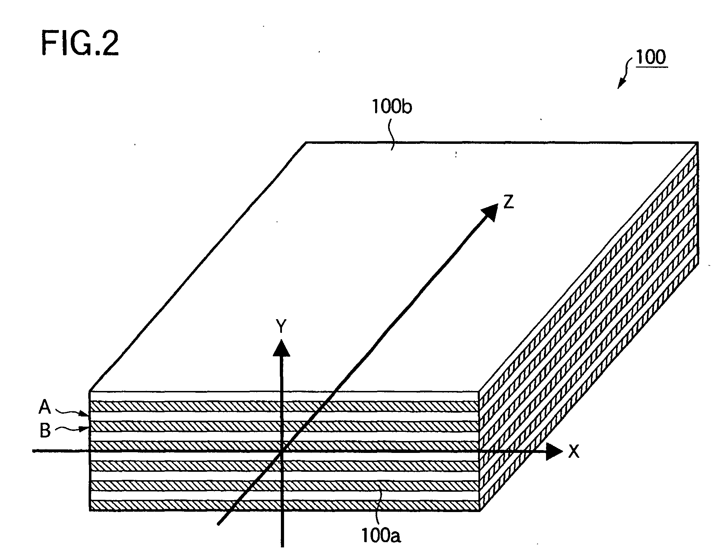

Fig. 2 is a perspective view showing an example of the periodic multilayer structure 100 which is a subject of the present invention. Materials A each having a refractive index $n_A$ and a thickness $t_A$ and materials B each having a refractive index $n_B$ and a thickness $t_B$ are laminated stratiformly alternately in a Y direction. Boundary surfaces between respective layers and a surface 100b are parallel to one another in an (X, Z) plane. Here, the boundary surfaces and the surface 100b are generically called "layer surfaces". The period $\underline{a}$ in the multilayer structure is equal to ($t_A + t_B$).

When analysis is made as to how beam with a wavelength $\lambda$ is propagated in the periodic multilayer structure 100 when the beam is incident on the end surface 100a (not parallel to the layer surfaces) of the periodic multilayer structure 100, it is found that the periodic multilayer structure 100 under a predetermined condition serves as so-called photonic crystal to thereby exhibit an effect peculiar to the propagated beam.

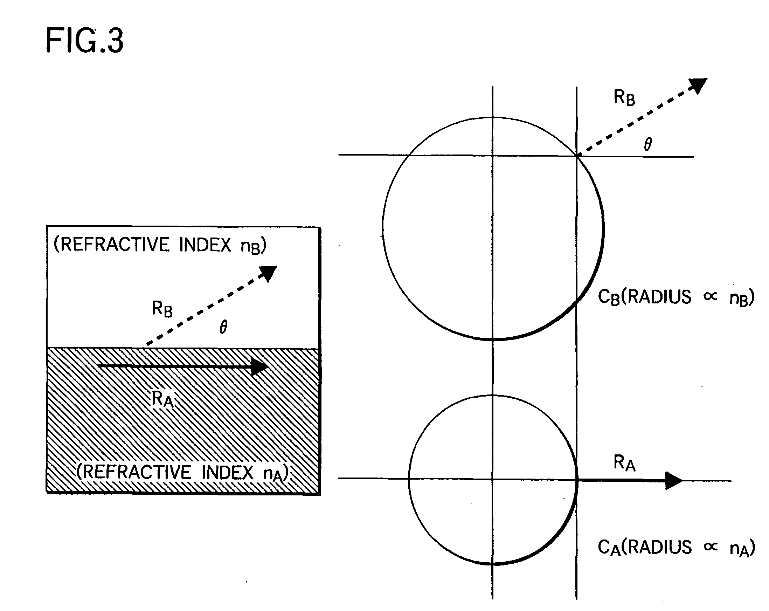

A method for expressing refraction of beam in a boundary between two media each homogeneous in refractive index by means of plotting will be described with reference to Fig. 3. Beam rays $R_A$, which advance along the vicinity of the medium A side boundary surface between the medium A with a refractive index $n_A$ and the medium B with a refractive index $n_B$ ($n_A < n_B$) so as to be parallel to the boundary surface, are emitted, as refracted beam $R_B$ with an angle $\theta$, to the medium side B.

This angle $\theta$ can be obtained on the basis of a graph plotted by use of two circles $C_A$ and $C_B$ with radii proportional to $n_A$ and $n_B$ respectively. As shown in Fig. 3, circles $C_A$ and $C_B$ are plotted. A vector having a direction corresponding to the beam rays $R_A$ is plotted as a line normal to the circle $C_A$. A line parallel to a line connecting the centers of the two circles $C_A$ and $C_B$ is plotted from a point on the circle $C_A$ to thereby obtain a point of intersection with the circle $C_B$. A vector plotted from this point of intersection in the direction of a line normal to the circle $C_B$ shows the direction of refracted beam $R_B$. This circle $C_A$ corresponds to the most basic photonic band in the case where beam with a wave-

length $\lambda$ propagates in a homogeneous material A.

A band graph for the periodic multilayer structure can be obtained by calculation on the basis of the principle of photonic crystal. The method of calculation has been described in detail in "Photonic Crystals", Princeton University Press, 1995, Physical Review B Vol. 44, No.16, p.8565, 1991, or the like.

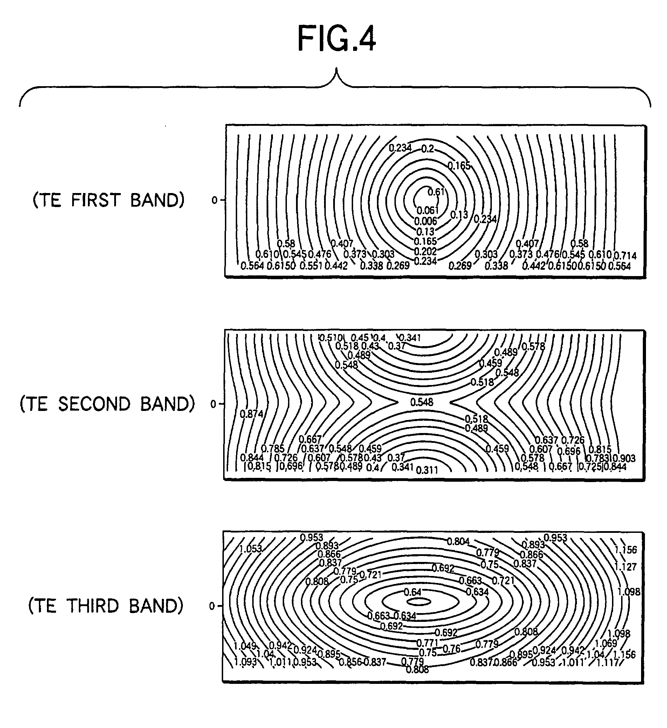

Assume that the periodic multilayer structure 100 in Fig. 2 has a periodic structure which is continuous infinitely in the Y direction (lamination direction) and is extended infinitely in the X and Z directions (the directions of spreading a plane) . Fig. 4 shows results of band calculation by a plane wave method, upon first, second and third bands of TE-polarized beam with respect to a plurality of wavelengths in the multilayer structure having a structure in which two kinds of layers represented by

$$n_A = 1.44 \ (t_A = 0.5a)$$

and

$$n_B = 2.18 \ (t_B = 0.5a)$$

are laminate alternately with a period of $\underline{a}$. Respective drawings in Fig. 4 show Brillouin zones each representing one period in a reciprocal space. The vertical axis represents the Y-axis direction in which the upper and lower boundaries express the range of $\pm\Pi/a$ from the center. The horizontal axis represents the Z-axis direction (or the X-axis direction) which has no boundary because the Z-axis direction is an aperiodic direction. The left and right ends in each of the graphs shown in Fig. 4 are provided to show the range of calculation for convenience' sake.

In each Brillouin zone, a position means a wave vector in the multilayer structure, and a curve means a band corresponding to the wavelength $\lambda$ (in a vacuum) of incident beam. Incidentally, numerical characters given to curves respectively in Fig. 4 are values of the ratio of cycle to wavelength ($a/\lambda$) in the multilayer structure. In a band graph of the periodic multilayer structure, discontinuity (so-called photonic band gap) occurs when $a/\lambda$ is larger than a certain value.

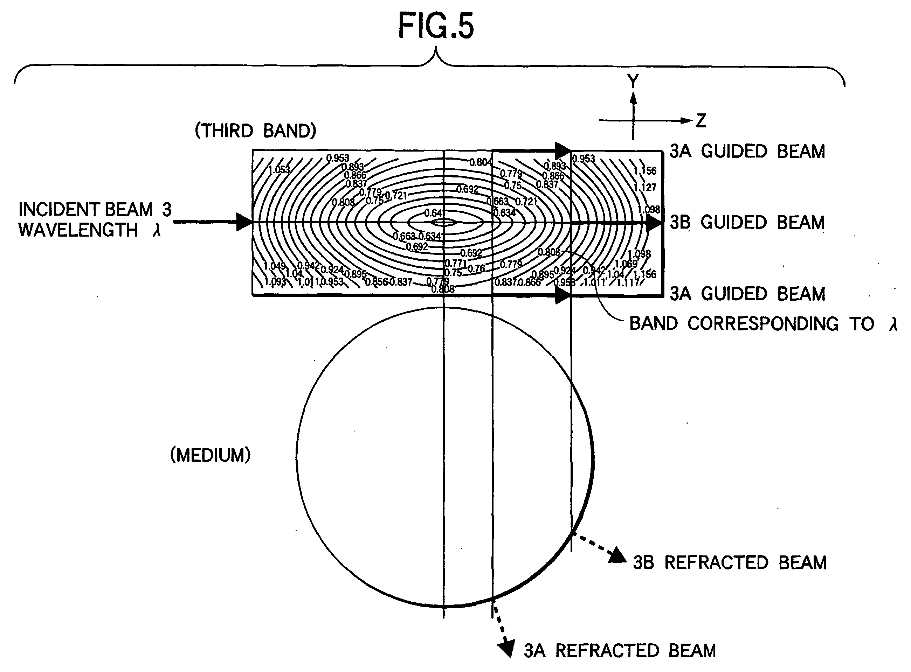

Fig. 5 shows the third band having the relation between guided beam in the Z-axis direction and refracted beam (leaked beam) thereof toward the medium tangent to the surface of the multilayer structure when incident beam 3 with a wavelength $\lambda$ enters the periodic multilayer structure. Because beam rays in the multilayer structure can be expressed as lines normal to curves shown in the band graph, the guided beams in the Z-axis direction in thethird band can be expressed as 3A and 3B in Fig. 5. According to the inventors' research, the intensity of the guided beam 3B is larger than that of the guided beam 3A. Each of the guide beams is made to exit as refracted beam from the boundary surface between the multilayer structure and the medium tangent to the surface of the multilayer structure. To emit the refracted beam, however, it is necessary that the refractive index of the medium expressed by the radius of each circle is higher than a predetermined value as is obvious from Fig. 5.

The angle θ of refracted beam with respect to the corresponding guided beam is kept approximately constant. Hence, it is expected the exit beam serves as luminous flux with very good directivity. Because the value of θ varies largely in accordance with the wavelength λ of incident beam, high-resolving-power wavelength separation can be achieved. Hence, the multilayer structure configured as shown in Fig. 1 can be applied to a sensitive wave length monitoring apparatus.

The periodic multilayer structure is not limited to the configuration owing to two kinds of materials as shown in Fig. 2. Three or more kinds of materials may be provided. It is, however, necessary to laminate the materials so that the refractive indices and thicknesses the respective layers have predetermined periodicity. The periodic multilayer structure is generally constituted by a laminate of $n$ ($n$ is a positive integer) kinds of materials. Assume that the refractive indices of materials 1, 2, ..., n forming one period are replaced by $n_1$, $n_2$, ..., $n_n$ respectively. Assume that the thicknesses of the materials 1, 2, ..., n are replaced by $t_1$, $t_2$, ..., $t_n$ respectively. The average refractive index $n_M$ per period of the multilayer structure with respect to the wavelength λ used is defined as follows:

$$n_M = (t_1 \cdot n_1 + t_2 \cdot n_2 + ... + t_n \cdot n_n)/a$$

in which $a$ is one period given by the following expression:

$$a = t_1 + t2 + ... + t_n$$

The condition concerning the average refractive index of the multilayer structure and the period of the multilayer structure suitable for the present invention can be given by the expression:

$$0.5\lambda/n_M \leq a$$

If this condition can be satisfied, the effect of photonic crystal can be fulfilled because $a/\lambda$ is larger than the band gap formed in the direction of lamination and near $0.5\lambda/n_M = a$. If the period $a$ is smaller than the range represented by the above condition, the characteristic of the multilayer structure becomes near to that of a homogeneous medium with the average refractive index.

The above description has been made upon the fact that the operation of the wavelength monitoring apparatus can be achieved when the periodic multilayer structure is used so that beam is made incident on the structure in a direction perpendicular to the direction of periodicity of the structure.

The configuration of the apparatus for monitoring the wavelength of a semiconductor laser (LD) by use of the aforementioned function will be described below. A core layer and a clad layer are epitaxially grown on a substrate by a suitable method such as an MOCVD method or an MBE method to thereby produce the LD. Laser beam can be made to exit from an end surface or a front surface of a film in accordance with the device structure of the LD. Although the laser of the type of emitting laser beam from an end surface is described here, the laser need not be limited to this type.

Beam made to exit from an end surface of the LD has an elliptic beam pattern. In use of such beam, generally, the beam needs to be condensed by use of a coupling device such as a lens. However, when such beam is to be coupled to a device having a waveguide structure, the beam exit end surface of the LD may be brought sufficiently near to the beam incidence end surface of the device so that coupling loss can be reduced to about 4 dB (see IEICE Trans. Electron., Vol.E80-C, No.1, p.107, 1997). In the present invention, the LD is disposed near to the multilayer film to perform optical coupling so that a condensing optical system through a lens can be omitted to reduce the size of the apparatus. Of course, beam emitted from the LD may be condensed by a condensing optical system such as a lens or the like so that the beam can be made incident on an end surface of the multilayer film.

A signal transmission optical fiber, a semiconductor laser or the like may be integrally disposed in accordance with various guide grooves produced accurately on a substrate so that the optical axes of respective parts can be made coincident with one another without alignment. Because the number of parts is so small that adjustment is little required, the purpose of wavelength monitoring can be achieved steadily and accurately. In such configuration, a compact low-cost LD beam source module having an optical signal transmission optical system integrated as well as the wavelength monitoring optical system can be achieved.

A specific configuration example will be described below.

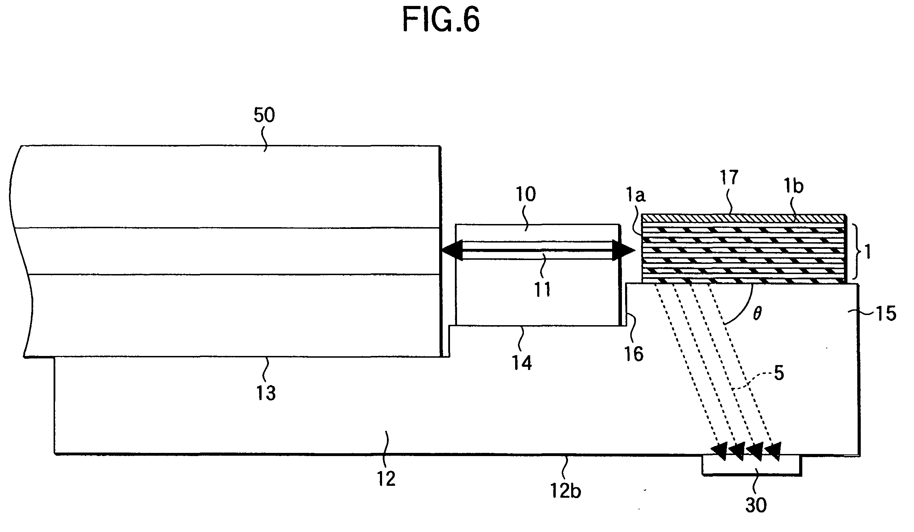

As shown in Fig. 6, a 0.3 mm-thick silicon substrate 12 was processed so that a guide groove 13 for an optical fiber 50, a groove 14 for mounting an LD, and a terrace 15 for forming a multilayer film were formed in the silicon substrate 12. When the multilayer film 1 was to be formed on the multilayer film-forming terrace 15, a level difference 16 was designed to be provided between the terrace 15 and the LD mounting groove 14 so that the central height of an end surface 1a of the multilayer film 1 was level with the height of an active layer 11 of the LD.

A silica layer having a thickness of about 10

μm was deposited on the surface of the silicon substrate 12 in the terrace portion 15 so as to be used as a buffer layer. A thin film of titanium oxide (thickness $t_2$ = 470 nm) and a thin film of silica (thickness $t_1$ = 470 nm) were formed successively on a surface of the buffer layer so as to form one period. This operation was repeated by 20 periods (40 layers) in total.

In this case, because leaked beam 5 was made to exit from the silicon substrate 12 side, a photodiode (photo detector, hereinafter abbreviated to "PD") 30 sensitive to a target wavelength to some extent was fixed to a rear surface 12b of the substrate 12 by an adhesive agent or the like so as to form a beam detecting means for monitoring the wavelength. The PD 30 was located in a position onto which the leaked beam having an exit angle θ of about 75° was incident, as shown in Fig. 6. Further, an InGaAsP/InP type LD having a wavelength λ near 1.3 μm was used as the LD 10. Incidentally, the leaked beam may be also sent out toward the air side above the multilayer film 1. In order to improve the intensity of the leaked beam on the substrate side, an optical refection layer 17 may be provided on the surface 1b of the multilayer film 1. A metal thin film or the like high in reflectance may be preferably used as the optical refection layer 17.

When the oscillation wavelength of the LD 10 fluctuates due to a factor such as temperature fluctuation or the like, the position of the rear surface of the substrate 12 where the leaked beam 5 reaches fluctuates. Hence, the output current of the PD 30 varies accordingly. When the current fluctuation is monitored, wavelength fluctuation of the LD 10 can be monitored.

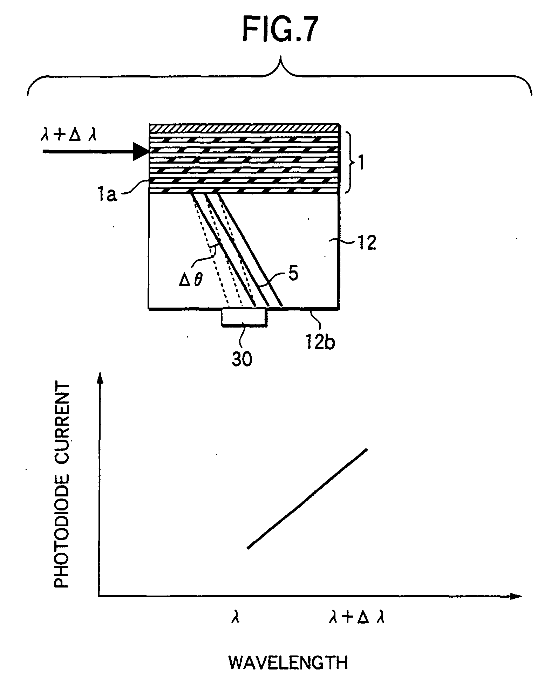

Fig. 7 shows the relation between the beam intensity detected by the PD 30 and the incident wavelength. Assuming now that beam having a wavelength λ is incident on the end surface 1a of the multilayer film 1, leaked beam 5 having a specific exit angle θ is generated. A PD 30 is mounted on a rear surface 12b of the substrate 12 in the position where the leaked beam 5 reaches. When the wavelength of the LD changes by Δλ due to somewhat factor such as temperature fluctuation or the like, the exit angle of the leaked beam 5 from the multilayer film 1 changes by Δθ. For this reason, the output current of the PD 30 having a definite beam-receiving surface changes in accordance with the change of the quantity of the incident beam. On this occasion, the relation between the output current of the PD 30 and the wavelength λ is shown in Fig. 7. That is, when fluctuation in the output current of the PD is monitored, a situation as to how the wavelength of LD 10 fluctuates can be found. For example, in the case of Fig. 7, as the output current of the PD increases, that is, as the beam intensity increases, it is found that the wavelength of the LD 10 is shifted to a long wavelength side. On the other hand, as the output current of the PD decreases, it is found that the wavelength of the LD 10 is shifted to a short wavelength side. Because it is found on the basis of such information that shifting of the wavelength of the LD 10 to the short wavelength side means the fall of the temperature of the LD 10, a signal for instructing a temperature controller to raise temperature can be sent to the temperature controller to thereby adjust the wavelength of the LD 10. On the other hand, when the wavelength of the LD 10 is shifted to the long wavelength side, a reverse operation can be performed.

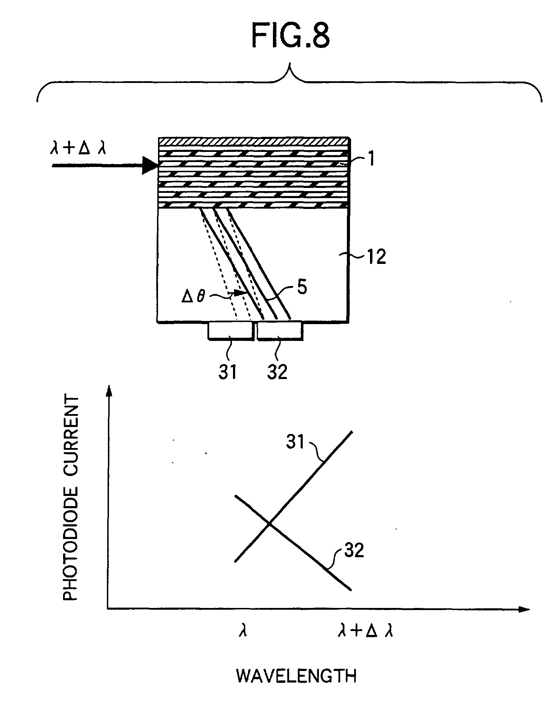

Further, two PDs 31 and 32 may be mounted adjacently as shown in Fig. 8. A ratio between output currents of the two PDs with respect to a normal wavelength is measured in advance. The ratio is preferably as near as 1:1. The ratio is monitored because the ratio fluctuates due to wavelength fluctuation. When only one PD is used for monitoring the absolute value of the output current, a cause of the output current fluctuation due to another factor such as temperature fluctuation than wavelength fluctuation cannot be identified. When the ratio between the outputs of the two PDs is used, the influence of temperature fluctuation or the like on output fluctuation can be removed.

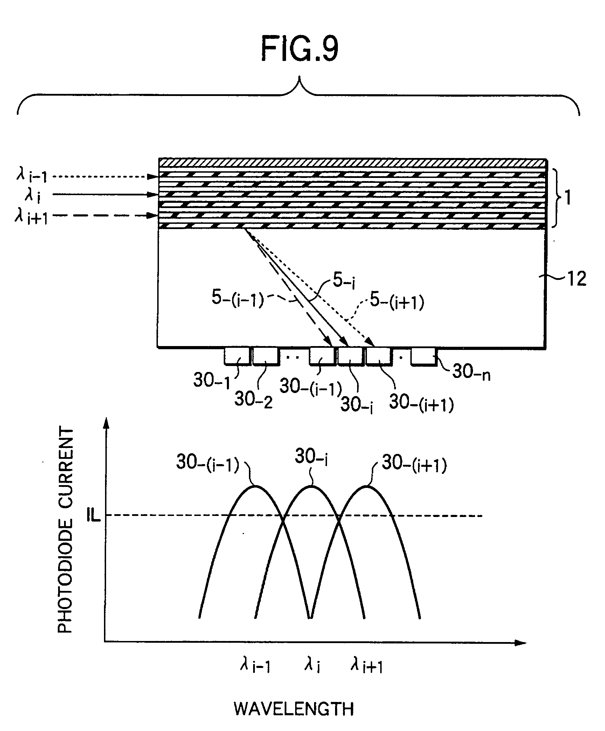

Further, another applied example will be described. When beams having wavelengths λ1, λ2, ... are incident on an end surface 1a of an optical device constituted by a multilayer film 1, leaked beams 5-1, 5-2, ... having different exit angles are generated. As shown in Fig. 9, a plurality of PD 30-1, 30-2, ... are mounted on a rear surface 12b of a substrate 12 in positions where the leaked beams reach. On this occasion, the relation between each of output currents of three adjacent PDs 30-(i-1), 30-i and 30-(i+1) and the wavelengths λ is shown in Fig. 9. Because the leaked beam 5-i with a wavelength λi reaches the central position of the PD 30-i but is hardly incident on the PDs 30-(i-1) and 30-(i+1) on the opposite sides of the PD 30-i, there are remarkable differences in intensity among beams detected by the PDs. Therefore, when a specific current level IL is determined as shown in Fig. 9 and compared with the output current of each PD, detection can be made as to whether a beam with a predetermined wavelength has reached the PD or not. Of course, the number of photodiodes may be increased in accordance with the number of wavelengths and the photodiodes may be arranged into the form of an array so that a plurality of wavelengths can be monitored.

Because the leaked beam from the multilayer film has strong directivity, the leaked beam reaches a very narrow range. When the width of the multilayer film is narrowed in advance, a slit effect can be also expected.

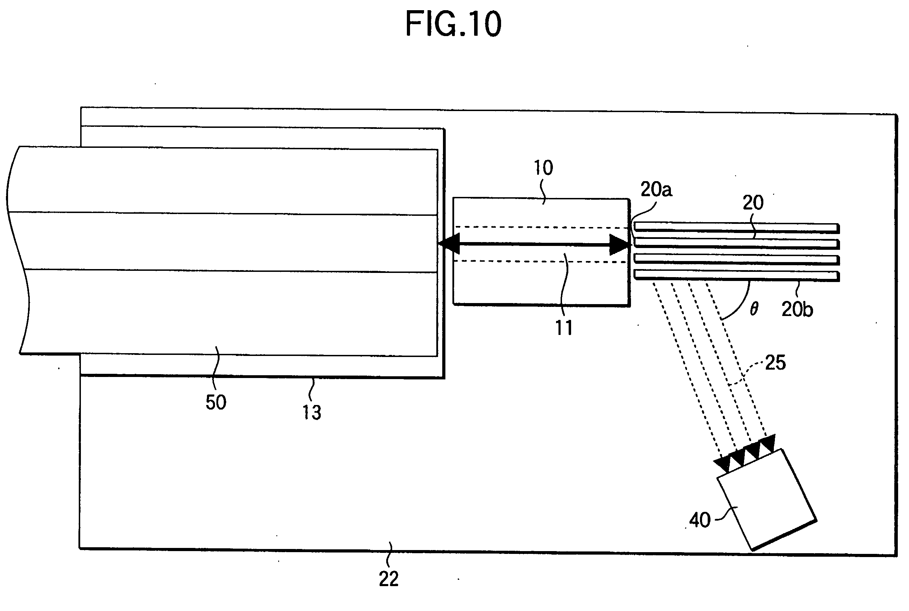

Although each of the above examples has been described upon the case where a periodic multilayer structure is achieved by a multilayer film, it is also possible to produce a periodic structure perpendicular to a substrate and apply the periodic structure to a periodic multilayer structure as shown in Fig. 10. Such a structure can be produced by a microprocessing technique. A specific method thereof will be described.

A photo resist is applied on a silicon substrate 22 and a photo mask is used so that a plurality of stripe-like patterns each having a desired interval and a desired thickness are exposed to beam and developed. The silicon substrate 22 masked with the photo resist patterns is etched with a suitable etching solution, so that a periodic multilayer structure 20 constituted by a combination of layers of silicon and layers of air perpendicular to the substrate 22 can be formed. An LD 10 is mounted on a substrate 22 so that exit beam can be coupled to an end surface 20a of the periodic multilayer structure 20. A groove 13 for fixing an optical fiber 50 into a predetermined position and a guide (not shown) used for positioning the LD 10 may be formed in and on the substrate.

When beam emitted from the LD 10 is made incident on the end surface 20a of the periodic multilayer structure 20, exit beam (leaked beam) 25 can be obtained at a specific angle θ to a surface 20b of the periodic multilayer structure 20 and in a direction parallel to the substrate 22. A PD 40 is mounted in a direction in which exit beam having a predetermined wavelength is made to exit. Preferably, the PD 40 is of a waveguide type. A plurality of PDs may be mounted in accordance with the purpose, similarly to the case of the multilayer film. A guide for determining the position of the PD 40 may be produced, similarly to the case of the LD. Further, a lens for condensing the leaked beam may be produced on one and the same substrate. In such configuration, because the exit beam 25 becomes parallel to the substrate 22, all the devices can be integrated on one and the same substrate to thereby bring further reduction in size of the apparatus.

As described above, in accordance with the present invention, a wavelength monitoring apparatus sensitive to a wavelength can be achieved without increase in apparatus size by use of the fact that beam leaked from a periodic multilayer film has good directivity and that the direction of the leaked beam has strong wavelength dependence. Because such multilayer films can be mass-produced relatively inexpensively by use of an existing technique, reduction in price of these optical devices can be attained. In addition, more compact devices can be formed by use of a microprocessing technique.

## Claims

1. A wavelength monitoring apparatus comprising:

   an optical device made of a periodic mutilayer structure;
   a beam source optically coupled to at least one end surface of said periodic multilayer structure, said one end surface being not parallel to layer surfaces of said periodic mutilayer structure; and
   beam detecting means for detecting beam made to exit from at least one surface of said periodic multilayer structure at a specific angle with respect to a specific wavelength, said one surface being parallel to said layer surfaces of said periodic mutilayer structure.

2. A wavelength monitoring apparatus according to claim 1, wherein said optical device is made of a multilayer film formed on a substrate transparent to the wavelength used.

3. A wavelength monitoring apparatus according to claim 1, wherein said optical device is made of the periodic multilayer structure having layer surfaces perpendicular to a surface of a substrate.

4. A wavelength monitoring apparatus according to claim 1, wherein said beam source is constituted by a semiconductor laser.

5. A wavelength monitoring apparatus according to claim 1, wherein said beam detecting means is constituted by at least one photo detector.

6. A wavelength monitoring apparatus according to claim 2, wherein said optical device, a semiconductor laser and a photo detector are mounted on one and the same substrate.

7. A wavelength monitoring apparatus according to claim 6, wherein beam emitted from said semiconductor laser is coupled to a beam incidence end surface of said multilayer film by level differences provided on said substrate on which said multilayer film is formed.

8. A wavelength monitoring apparatus according to claim 6, wherein said photo detector is provided on a surface opposite to said surface of said substrate on which said multilayer film is formed.

9. A wavelength monitoring apparatus according to claim 3, wherein said optical device, a semiconductor laser and a photo detector are mounted on one and the same substrate.

10. A wavelength monitoring apparatus comprising:

    an optical device having a periodic multilayer structure, said periodic multilayer structure defining, at least, a first surface substantially perpendicular to layer surfaces of the periodic multilayer structure and a second surface substantially parallel to the layer surfaces of the periodic multilayer structure;
    a semiconductor laser confronted with said first surface; and
    a photo detector confronted with said second surface.

**11.** A wave length monitoring apparatus according to claim 10, further comprising:

    a common substrate supporting said optical device, said semiconductor laser and said photo detector.

**12.** A wave length monitoring apparatus according to claim 11, wherein said substrate is transparent, and is contacted with the second surface of said periodic multilayer structure.

**13.** A wave length monitoring apparatus according to claim 11, wherein said substrate is contacted with a surface of said periodic multilayer structure other than said first and second surfaces.

# FIG.1

# FIG.2

EP 1 219 939 A2

# FIG.3

(REFRACTIVE INDEX $n_B$)

$R_B$

$\theta$

$R_A$

(REFRACTIVE INDEX $n_A$)

$R_B$

$\theta$

$C_B$(RADIUS $\propto n_B$)

$R_A$

$C_A$(RADIUS $\propto n_A$)

# FIG.4

(TE FIRST BAND)

(TE SECOND BAND)

(TE THIRD BAND)

# FIG.5

(THIRD BAND)

3A GUIDED BEAM

INCIDENT BEAM 3
WAVELENGTH λ

3B GUIDED BEAM

3A GUIDED BEAM

BAND CORRESPONDING TO λ

(MEDIUM)

3B REFRACTED BEAM

3A REFRACTED BEAM

EP 1 219 939 A2

# FIG.6

EP 1 219 939 A2

# FIG.7

# FIG.8

# FIG.9

PHOTODIODE CURRENT

WAVELENGTH

# FIG.10

EP 1 219 939 A2

# FIG.11

FRONT SIDE :
TRANSMISSION SYSTEM

BACK SIDE :
MONITORING SYSTEM

EP 1 219 939 A2